# EUROPEAN PATENT APPLICATION

(11) **EP 4 814 502 A1**
(43) Date of publication of application: **30.09.2026**
(21) Application number: 24893651.0
(22) Date of filing: 11.11.2024
(51) Int. Cl.: G01R 19/25, G01R 27/08, H01F 27/00, H02J 3/01

(54) **USE OF SHORT-CIRCUIT RESISTANCES, METHOD AND DEVICE FOR MONITORING THE OPERATING STATE OF AN OPERATIONAL THREE PHASE TRANSFORMER**

(30) Priority: 23.11.2023 ES 202330968
(71) Applicant: Universitat Politécnica de Valencia, 46022 Valencia (ES)
(72) Inventor: LEON MARTINEZ, Vicente, 46022 Valencia (ES); MONTAÑANA ROMEU, Joaquin, 46022 Valencia (ES); PEÑALVO LOPEZ, Elisa, 46022 Valencia (ES)
(74) Representative: Maslanka Kubik, Dorota Irena
(86) International application number: PCT/ES2024/070697
(87) International publication number: WO 2025/109231

(57) **Abstract**

The invention describes a use of short-circuit resistances, a method and a device (A) for monitoring the operating state of an operational three-phase transformer (G). The effective short-circuit resistance relating to a *z* phase of the secondary winding of the transformer is that which gives rise to load losses when current circulates through the phase. The method comprises obtaining one or more magnitudes, such as short-circuit resistances of each harmonic, effective short-circuit resistances of each *z* phase, load losses of each *z* phase, load losses of each harmonic, total load losses, factors of overheating and of supply of each *z* phase, factor of supply of the transformer, factor of losses of each harmonic. The device (A) comprises a physical system for measuring and acquiring electrical signals (C); a processing system (D); and a measuring program (E).

## Description

### TECHNICAL FIELD

The present invention generally relates to the field of three-phase distribution transformers and, more specifically, to the monitoring of their operation.

### BACKGROUND OF THE INVENTION

Short-circuit resistances are extremely important operating parameters of electrical transformers. During typical operation of these machines, short-circuit resistances determine the values of load losses and, therefore, of overheating, which lead to the deterioration of their constructive elements and to their shorter service life.

Three-phase distribution transformers grids are mostly of the Dyn11 type. In industrial practice, the following expression is fairly widely used to calculate load losses, also known as copper losses, during the operation of these transformers: ${P}_{cc} = {R}_{ccN} ⋅ \left({I}_{2 R}^{2}+{I}_{2 S}^{2}+{I}_{2 T}^{2}\right)$ wherein *P_{cc}* are the load losses; *I*_{2*R*}, *I*_{2*S*}, *I*_{2*T*} are the effective values of the currents circulating through the phases of the secondary winding; and *R_{ccN}* is the short-circuit resistance that is reduced or relating to the secondary winding, obtained as follows: ${R}_{ccN} = \frac{{P}_{ccN}}{3 ⋅ {I}_{2 N}^{2}}$ where *P_{ccN}* is the value of the nominal load losses; and *I*_{2*N*} is the effective value of the nominal current of the secondary winding. These magnitudes can be known from the catalogue data provided by the manufacturers of the transformers, or else it can be obtained after performing a nominal short-circuit test at the industrial frequency (50 - 60 Hz).

The application of equation [1] provides the same results as IEEE Standard C57.110 when the transformers power linear loads, without harmonics. This is not the standard operation of transformers in distribution grids, because the increasingly greater presence of electronic converters in the regulation of electric motors, in lighting and photovoltaic solar energy systems, among other applications, causes the circulation of distorted currents through the windings. **IEEE** Standard C57.110-2018 (DOI: 10.1109/IEEESTD.2018.8511103) establishes the expressions of load losses of three-phase transformers supplying nonlinear loads. Total load losses (*P_{LL}*) are obtained as the sum of direct current losses (*P_{DC}*), losses due to the Skin effect (*P_{EC}*) and losses caused by currents induced in the walls of the tank and other metallic parts of the transformer (*P_{OSL}*): ${P}_{LL} = {P}_{DC} + {P}_{EC} + {P}_{OSL} = {\sum }_{h = 1}^{{h}_{max}} \left({P}_{DC - R}+{P}_{EC - R}⋅{h}^{2}+{P}_{OSL - R}⋅{h}^{0 , 8}\right) ⋅ {\left(\frac{{I}_{h}}{{I}_{R}}\right)}^{2}$

In these expressions, *P_{DC-R}* are direct current nominal losses, *P_{EC-R}* are nominal losses due to the Skin effect and *P_{OSL-R}* are nominal losses caused by the phenomenon of electromagnetic induction; *Iₕ* is the effective value of each harmonic of the currents of the primary winding, *h = fₕ*/*f*₁ is the order of each harmonic of the currents of the primary winding (ratio between its frequency, *fₕ,* and the fundamental frequency, *f*₁ = 50 - 60 *Hz), hₘₐₓ* is the order of the harmonic of the highest frequency used in the calculation, and *I_{R}* is the nominal value of the current of the primary winding of the transformer.

Expression [3] provides correct results when the currents are exactly the same in the three phases of the transformer, i.e., they have the same effective values (*Iₕ = I_{hR} = I_{hS} = I_{hT}*) and harmonics of the same frequencies (*h = h_{R} = h_{S} = h_{T}*)*.* This latter sameness is typically common in electrical grids; however, it is highly unlikely that the effective values of each harmonic of the currents are the same in the three phases of the distribution transformers.

Notwithstanding the above, the expressions of the load losses indicated in [3] have been used by a number of publications in the technical literature. By way of example, the two following applications, among many others, are cited:
1. Megahed, T.F.; Kotb, M.F. Improved design of LED lamp circuit to enhance distribution transformer capability based on a comparative study of various standards. Elsevier Energy Reports 2022, 8 (9), pp. 445-465. https://doi.org/10.1016/j.egyr.2022.07.027
2. Daniel Contreras Ramírez & Lata-García Juan. K-Factor Analysis to Increase the Actual Capacity of Electrical Distribution Transformers. Springer Communication, Smart Technologies and Innovation for Society, 2021, pp 367-379. https://doi.org/10.1007/978-981-16-4126-8_34

However, neither of these publications or the standard explains how to use expression [3] in the general case where the currents have different effective values (*Iₕ*) and harmonics (*h*) in each phase of the transformer. Nor is it possible to calculate the load losses of each phase of the transformer by applying equation [3], given that *P_{DC-R},P_{EC-R}* and *P_{OSL-R}* are total nominal losses, not the losses in each phase.

Likewise, IEEE Standard C57.110 does not establish expressions to calculate the short-circuit resistance of three-phase transformers supplying nonlinear loads. Nor have any expressions of the short-circuit resistance of transformers supplying nonlinear loads been found in any of the consulted literature references, with the exception of the following, very recently established by L. Sima *et al.*:
Sima, L.; Miteva, N.; Dagan, K.J. A novel approach to power loss calculation for power transformers supplying nonlinear loads. Elsevier Electric Power Systems Research 2023, 223, 109582. https://doi.org/10.1016/j.epsr.2023.109582

In this reference, L. Sima *et al.* have established expressions of the short-circuit resistance relating to the primary winding (*Rₖ*) based on the application of IEEE Standard C57.110, which can basically be reduced to the following: ${R}_{k} = {R}_{DC} + {R}_{EC} + {R}_{OSL} = \left({R}_{DCp}+{k}^{2}{R}_{DCs}\right) + \left({R}_{ECp}+{k}^{2}{R}_{ECs}\right) + {R}_{OSL} = \frac{{P}_{K}}{{I}_{p}^{2}}$ wherein *R_{DC}* is the direct current short-circuit resistance, *R_{EC}* is the resistance due to the Skin effect, and *R_{OSL}* is the resistance due to losses *P_{OSL}*; subscript *p* indicates a parameter of the primary winding and subscript *s* indicates a parameter of the secondary winding. *P_{K} = P_{LL}* are the total load losses defined by IEEE Standard C57.110 in equation [3] and *Iₚ* is the effective value of the current of the three phases of the primary winding.

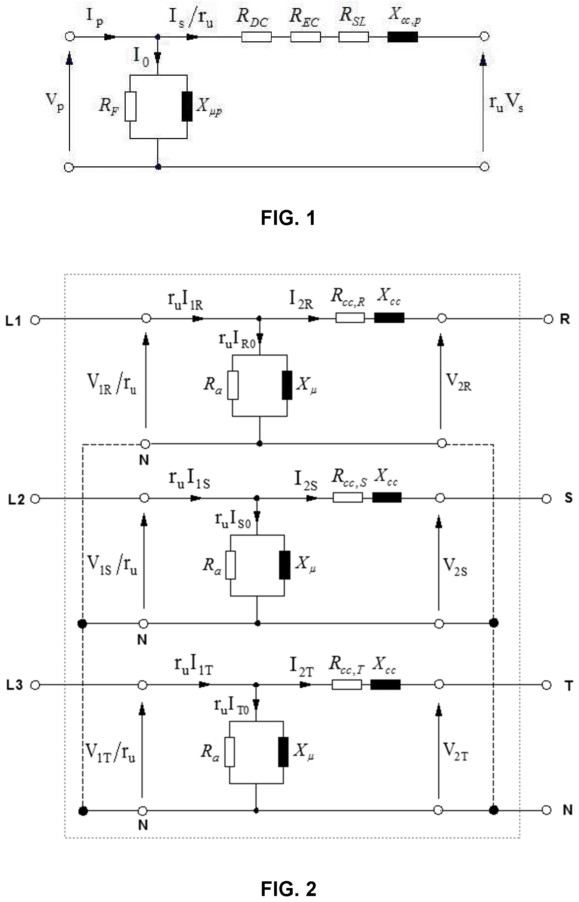

The substitution in equation [5] of the values of the load losses calculated according to equation [3] determines that *Rₖ* has the same values in the three phases of the transformer. This result is consistent with the limitations of use of the expression of the load losses included in IEEE Standard C57.110, indicated above, and determines an equivalent model of the three-phase transformer with the same elements and values in the three phases of the transformer, as depicted in the equivalent single-phase circuit of Figure 1, used by L. Sima *et al.* in their publication.

The equivalent three-phase transformer model proposed by L. Sima *et al.* (Figure 1), resulting from the direct application of IEEE Standard C57.110, is not physically correct, given that short-circuit resistances may have different values in the three phases of the transformer when the currents are not exactly the same in each one of them. This is confirmed by the strong dependence that the values of resistances *R_{EC}* and *R_{OSL},* components of *Rₖ* in equation [5], have on the frequencies of the harmonics (*h*) and on the effective values (*Iₕ*) of the currents, which are usually different in the three phases of the transformer, as indicated above.

In summary, the equivalent operation model of three-phase transformers supplying nonlinear loads is closer to the one depicted in Figure 2, in which short-circuit resistances have different values in each phase. The short-circuit resistance developed by L. Sima *et al.* (*Rₖ*) is a merely mathematical parameter, the only application of which is the calculation of total load losses of the transformer, but it does not allow the real operation or the value of the losses in each of its phases to be known.

### SUMMARY OF THE INVENTION

To solve the mentioned drawbacks of the prior art, according to a first aspect, the present invention discloses a use of short-circuit resistances for monitoring the operating state of an operational three-phase transformer. Said resistances are effective short-circuit resistances relating to the secondary winding of the three-phase transformer, with the particularity that the effective short-circuit resistance relating to a *z* phase of the secondary winding (*R_{cc,z}*) is that which gives rise to dissipated load losses in the *z* phase (*P_{cc,z}*) when current circulates through the z phase, as shown in the following expression: ${R}_{cc , z} = \frac{{P}_{cc , z}}{{\sum }_{{h}_{z} = 1}^{{h}_{z , max}} {I}_{hz}^{2}}$ wherein:
- z generally denotes any one phase of the secondary winding of the transformer,
- *R_{cc,z}* is the effective short-circuit resistance relating to the *z* phase of the transformer,
- *P_{cc,z}* are the dissipated load losses in the *z* phase,
- *h_{z}* is the order of a current harmonic present in the z phase, said order being defined as the ratio between the harmonic frequency (*fₕ*) and the fundamental frequency (*f*₁),
- *h_{z,max}* is the order of the current harmonic of the highest frequency present in the z phase used in the calculation,
- *I_{hz}* is the effective value of the current harmonic of order *h_{z}.*

The use of short-circuit resistances based on the technology of the present invention allows real losses in each phase to be calculated and, therefore, the overheating, the reduced power transmission capability and shorter service life of the transformer to be known. Short-circuit resistances have been applied in the present invention to the development of parameters suitable for monitoring the operating state of distribution transformers, such as a factor of overheating of each phase, a factor of supply of each phase, a factor of supply of the transformer and a factor of losses of each harmonic, as included below.

According to a second aspect, the present invention also provides a method for monitoring the operating state of an operational three-phase transformer based on the use of short-circuit resistances of the first aspect of the invention. The method comprises obtaining, by means of a monitoring device, the value of at least one magnitude of the transformer selected from the group comprising: short-circuit resistances of harmonics relating to the secondary winding of the transformer (*R_{cc,h}*)*,* short-circuit resistances of harmonics relating to the primary winding of the transformer, effective short-circuit resistances relating to the secondary winding of the transformer (*R_{cc,z}*), component of said effective short-circuit resistances due to the Skin effect (*R_{EC,z}*), component of said effective short-circuit resistances due to the phenomenon of electromagnetic induction (*R_{OSL,z}*), effective short-circuit resistances relating to the primary winding of the transformer, load losses of each phase of the secondary winding of the transformer (*P_{cc,z}*), load losses of each harmonic (*P_{cc,h}*), total load losses (*P_{cc}*), factor of overheating of each phase (*FC_{z}*), factor of supply of each phase (*FS_{z}*%), factor of supply of the transformer *(FST%),* factor of losses of each harmonic (*FPₕ*%), according to the following particularities:
a) the value of short-circuit resistances of harmonics relating to the secondary winding of the transformer (*R_{cc,h}*) is obtained by means of expression [32]: ${R}_{cc , h} = {R}_{DCN} + {R}_{ECN} ⋅ {h}_{z}^{2} + {R}_{OSLN} ⋅ {h}_{z}^{0.8}$ wherein:
   - *R_{cc,h}* is the short-circuit resistance of a current harmonic relating to the *z* phase of the secondary winding of the transformer,
   - *z* generally denotes any one phase of the secondary winding of the transformer,
   - *h_{z}* is the order of a current harmonic present in the *z* phase, said order being defined as the ratio between the harmonic frequency (*fₕ*) and the fundamental frequency (*f*₁),
   - *R_{DCN}, R_{ECN}, R_{OSLN}* are a direct current nominal short-circuit resistance relating to the secondary winding (*R_{DCN}*), a nominal short-circuit resistance relating to the secondary winding due to the Skin effect (*R_{ECN}*) and a nominal short-circuit resistance relating to the secondary winding caused by electromagnetic induction in the metallic parts of the transformer (*R_{OSLN}*), respectively, which are obtained by means of expressions [26] ${R}_{DCN} = \frac{{P}_{DCN}}{3 {I}_{2 N}^{2}} {R}_{ECN} = \frac{{P}_{ECN}}{3 {I}_{2 N}^{2}} {R}_{OSLN} = \frac{{P}_{OSLN}}{3 {I}_{2 N}^{2}}$ wherein:
      · *P_{DCN}* are direct current nominal load losses,
      · *P_{ECN}* are nominal load losses due to the Skin effect,
      · *P_{OSLN}* are nominal load losses caused by the phenomenon of electromagnetic induction,
      · *I*_{2*N*} is the nominal value of the current of the secondary winding of the transformer;
b) the value of short-circuit resistances of harmonics relating to the primary winding of the transformer is obtained by multiplying the short-circuit resistances of current harmonics relating to the secondary winding of the transformer (*R_{cc,h}*) by the square of a turns ratio of the transformer *rᵤ* = *V*₁/*V*₂₀, wherein:
   - *V*₁ is the effective value of the voltage of the primary winding, and
   - *V*₂₀ is the effective value of the no-load voltage of the secondary winding;
c) the value of the effective short-circuit resistances relating to the secondary winding of the transformer (*R_{cc,z}*) is obtained by means of one of the following options:
   c1) by means of expression [25]: ${R}_{cc , z} = {R}_{DCN} + {R}_{ECN} ⋅ {F}_{ECL}^{z} + {R}_{OSLN} ⋅ {F}_{OSL}^{z}$ wherein:
      - *R_{cc,z}* is the effective short-circuit resistance relating to the z phase of the transformer,
      - *R_{DCN}, R_{ECN}, R_{OSLN}* are a direct current nominal short-circuit resistance relating to the secondary winding (*R_{DCN}*), a nominal short-circuit resistance relating to the secondary winding due to the Skin effect (*R_{ECN}*) and a nominal short-circuit resistance relating to the secondary winding caused by electromagnetic induction in the metallic parts of the transformer (*R_{OSLN}*), respectively, which are obtained by means of expressions [26] ${R}_{DCN} = \frac{{P}_{DCN}}{3 {I}_{2 N}^{2}} {R}_{ECN} = \frac{{P}_{ECN}}{3 {I}_{2 N}^{2}} {R}_{OSLN} = \frac{{P}_{OSLN}}{3 {I}_{2 N}^{2}}$ wherein:
         · *P_{DCN}* are direct current nominal load losses,
         · *P_{ECN}* are nominal load losses due to the Skin effect,
         · *P_{OSLN}* are nominal load losses caused by the phenomenon of electromagnetic induction,
         · *I*_{2*N*} is the nominal value of the current of the secondary winding of the transformer;
      - ${F}_{ECL}^{z} , {F}_{OSL}^{z}$ are a factor of losses of the *z* phase due to the Skin effect ( ${F}_{ECL}^{z}$), and a factor of losses of the *z* phase caused by electromagnetic induction in the metallic parts of the transformer ( ${F}_{OSL}^{z}$)*,* respectively, which are obtained by means of expressions [27] ${F}_{ECL}^{z} = \frac{{\sum }_{{h}_{z} = 1}^{{h}_{z , max}} {h}_{z}^{2} ⋅ {I}_{hz}^{2}}{{\sum }_{{h}_{z} = 1}^{{h}_{z , max}} {I}_{hz}^{2}} {F}_{OSL}^{z} = \frac{{\sum }_{{h}_{z} = 1}^{{h}_{z , max}} {h}_{z}^{0.8} ⋅ {I}_{hz}^{2}}{{\sum }_{{h}_{z} = 1}^{{h}_{z , max}} {I}_{hz}^{2}}$ wherein:
         · *h_{z}* is the order of a current harmonic present in the *z* phase, said order being defined as the ratio between the harmonic frequency (*fₕ*) and the fundamental frequency (*f*₁),
         · *h_{z,max}* is the order of the current harmonic of the highest frequency present in the *z* phase used in the calculation,
         · *I_{hz}* is the effective value of the current harmonic of order *h_{z}*;
   c2) by means of expression [29] ${R}_{cc , z} = \frac{{\sum }_{{h}_{z} = 1}^{{h}_{z , max}} {R}_{cc , h} ⋅ {I}_{hz}^{2}}{{\sum }_{{h}_{z} = 1}^{{h}_{z , max}} {I}_{hz}^{2}}$ wherein:
      - *R_{cc,z}* is the effective short-circuit resistance relating to the *z* phase of the transformer,
      - *R_{cc,h}* is the short-circuit resistance of a current harmonic relating to the *z* phase of the secondary winding of the transformer,
      - *h_{z}* is the order of a current harmonic present in the *z* phase, said order being defined as the ratio between the harmonic frequency (*fₕ*) and the fundamental frequency (*f*₁),
      - *h_{z,max}* is the order of the current harmonic of the highest frequency present in the *z* phase used in the calculation,
      - *I_{hz}* is the effective value of the current harmonic of order *h_{z}*;
d) the value of the component due to the Skin effect (*R_{EC,z}*) of the effective short-circuit resistances of each phase relating to the secondary winding (*R_{cc,z}*) is obtained by means of expression [28.1] ${R}_{EC , z} = {R}_{ECN} ⋅ {F}_{ECL}^{z}$ wherein:
   - *R_{ECN}* are the nominal load losses due to the Skin effect,
   - ${F}_{ECL}^{z}$ is the factor of losses of the z phase due to the Skin effect;
e) the value of the component due to the phenomenon of electromagnetic induction (*R_{OSL,z}*) of the effective short-circuit resistances of each phase relating to the secondary winding (*R_{cc,z}*) is obtained by means of expression [28.2] ${R}_{OSL , z} = {R}_{OSLN} ⋅ {F}_{OSL}^{z}$ wherein:
   - *R_{OSLN}* is the nominal short-circuit resistance relating to the secondary winding caused by electromagnetic induction in the metallic parts of the transformer,
   - ${F}_{OSL}^{z}$ is the factor of losses of the *z* phase caused by electromagnetic induction in the metallic parts of the transformer;
f) the value of the effective short-circuit resistances relating to the primary winding of the transformer is obtained by multiplying the effective short-circuit resistances relating to the secondary winding of the transformer (*R_{cc,z}*) by the square of a turns ratio of the transformer *rᵤ* = *V*₁/*V*₂₀, wherein:
   - *V*₁ is the effective value of the voltage of the primary winding, and
   - *V*₂₀ is the effective value of the no-load voltage of the secondary winding;
g) the value of the load losses of each phase of the secondary winding of the transformer (*P_{cc,z}*) is obtained by means of one of the following options:
   g1) by means of expression [30] ${P}_{cc , z} = {R}_{cc , z} ⋅ {\sum }_{{h}_{z} = 1}^{{h}_{z , max}} {I}_{hz}^{2}$ wherein:
      - *R_{cc,z}* is the effective short-circuit resistance relating to the *z* phase of the transformer,
      - *h_{z}* is the order of a current harmonic present in the *z* phase, said order being defined as the ratio between the harmonic frequency (*fₕ*) and the fundamental frequency (*f*₁),
      - *h_{z,max}* is the order of the current harmonic of the highest frequency present in the *z* phase used in the calculation,
      - *I_{hz}* is the effective value of the current harmonic of order *h_{z}*;
   g2) by means of expression [34] ${P}_{cc , z} = {\sum }_{{h}_{z} = 1}^{{h}_{z , max}} {R}_{cc , h} ⋅ {I}_{hz}^{2}$ wherein:
      - *h_{z}* is the order of a current harmonic present in the *z* phase, said order being defined as the ratio between the harmonic frequency (*fₕ*) and the fundamental frequency (*f*₁),
      - *h_{z,max}* is the order of the current harmonic of the highest frequency present in the *z* phase used in the calculation,
      - *R_{cc,h}* is the short-circuit resistance of a current harmonic relating to the *z* phase of the secondary winding of the transformer,
      - *I_{hz}* is the effective value of the current harmonic of order *h_{z}*;
h) the value of the load losses of each harmonic (*P_{cc,h}*) is obtained by means of expression [33]: ${P}_{cc , h} = {R}_{cc , h} ⋅ {\sum }_{z = R , S , T} {I}_{hz}^{2}$ wherein:
   - *z* generally denotes any one phase of the secondary winding of the transformer,
   - *R, S, T* specifically denote each of the three phases of the secondary winding of the transformer, respectively,
   - *I_{hz}* is the effective value of the current harmonic of order *h_{z},*
   - *R_{cc,h}* is the short-circuit resistance of a current harmonic relating to the *z* phase of the secondary winding of the transformer;
i) the value of the total load losses (*P_{cc}*) is obtained by means of one of the following options:
   i1) by means of expression [31]: ${P}_{cc} = {\sum }_{z = R , S , T} {P}_{cc , z}$ wherein:
      - *z* generally denotes any one phase of the secondary winding of the transformer,
      - *R, S, T* specifically denote each of the three phases of the secondary winding of the transformer, respectively,
      - *P_{cc,z}* are the load losses of each phase of the secondary winding of the transformer;
   i2) by means of expression [35]: ${P}_{cc} = {\sum }_{{h}_{z} = 1}^{{h}_{z , max}} {P}_{cc , h}$ wherein:
      - *h_{z}* is the order of a current harmonic present in the *z* phase, said order being defined as the ratio between the harmonic frequency (*fₕ*) and the fundamental frequency (*f*₁),
      - *h_{z,max}* is the order of the current harmonic of the highest frequency present in the *z* phase used in the calculation,
      - *P_{cc,h}* are the load losses of each harmonic;
j) the value of the factor of overheating of each phase (*FC_{z}*) is obtained by means of expression [36]: ${FC}_{z} = \frac{{R}_{cc , z}}{{R}_{cc , 1}}$ wherein:
   - *FC_{z}* is the factor of overheating of each *z* phase, which defines the increase in losses in each *z* phase in relation to the losses there would be in the transformer operating without nonlinear loads,
   - *R_{cc,z}* is the effective short-circuit resistance relating to the z phase of the transformer,
   - *R*_{*cc,*1} is the short-circuit resistance of a harmonic (*R_{cc,h}*) at the fundamental frequency, i.e., of the harmonic of order *h*=1;
k) the value of the factor of supply of each phase (*FS_{z}*%) is obtained by means of expression [37]: ${FS}_{z} % = \frac{1}{\sqrt{{FC}_{z}}} ⋅ 100$ wherein:
   - *FS_{z}*% is the factor of supply of each phase, which measures the percentage value of the maximum admissible current and of the power supply in each phase in relation to what the transformer would have operating with linear loads, without harmonics,
   - *FC_{z}* is the factor of overheating of each *z* phase, expressed on a per unit basis;
l) the value of the factor of supply of the transformer *(FST%)* is obtained by means of expression [38]: $FST% = \sqrt{\frac{{\sum }_{z = R , S , T} {\left({FS}_{z}\right)}^{2}}{3}} ⋅ 100$ wherein:
   - *FST%* is the factor of supply of the transformer, which determines the maximum percentage availability of power supply in relation to what the transformer would have operating with linear loads,
   - *z* generally denotes any one phase of the secondary winding of the transformer,
   - *R, S, T* specifically denote each of the three phases of the secondary winding of the transformer, respectively,
   - *FS_{z}* is the factor of supply of each *z* phase, expressed on a per unit basis;
m) the value of the factor of losses of each harmonic (*FPₕ*%) is obtained by means of expression [39]: ${FP}_{h} % = \frac{{P}_{cc , h}}{{P}_{cc , 1}} ⋅ 100$ wherein:
   - *FPₕ*% is the factor of losses of each harmonic, which defines the percentage importance of each current harmonic in the load losses of the transformer at the fundamental frequency,
   - *P_{cc,h}* are the load losses of the harmonic of order *h,*
   - *P*_{*cc*,1} are the load losses of the fundamental harmonic, i.e., the harmonic of order *h*=1.

According to a third aspect, the present invention also provides a device for monitoring the operating state of an operational three-phase transformer based on the use of short-circuit resistances of the first aspect of the invention. The device allows the method of the second aspect of the invention to be carried out. The device comprises:
- a physical system for measuring and acquiring electrical signals;
- a processing system; and
- a measuring program in charge of obtaining the value of one or more electrical magnitudes of the transformer subjected to monitoring when it supplies loads.

Herein, the word "comprises" and variants thereof are to be interpreted as open type expressions that do not intend to exclude the possibility of other technical features or components in addition to those explicitly mentioned. Furthermore, the word "comprises" includes the case of "consists of", being interpreted as a closed-type expression which is limited only to the technical features or components explicitly mentioned. For those skilled in the art, other objects, advantages and features of the invention will be inferred in part from the description and in part from the practice of the invention. Furthermore, the present invention covers all the possible combinations of embodiments indicated here.

### BRIEF DESCRIPTION OF THE DRAWINGS

The present invention will be better understood in reference to the following figures, where the following is depicted in an illustrative and non-limiting manner:
Figure 1 schematically depicts the equivalent single-phase circuit, relating to the primary winding, for the operation of three-phase transformers, on which the technology proposed by L. Sima *et al*. and IEEE Standard C57.110 is based.
Figure 2 schematically depicts the equivalent circuit, relating to the secondary winding, for the operation of three-phase transformers on which the technology of the present invention is based.
Figure 3 is a diagram showing the operating sequence of a method for calculating the different effective short-circuit resistances, the load losses and the factors of monitoring operational three-phase transformers, according to a preferred embodiment of the present invention, applicable to instruments for measuring and monitoring three-phase transformers.
Figure 4 is a diagram depicting a device for measuring short-circuit resistances and load losses of three-phase transformers with several sensors installed in the electrical grid, according to a preferred embodiment of the present invention.
Figure 5 is a diagram depicting the programming modules for measuring in each phase effective short-circuit resistances, load losses, coefficients of overheating and factors of supply of three-phase transformers, according to a preferred embodiment of the present invention.
Figure 6 is a diagram depicting the programming modules for measuring short-circuit resistances, load losses and factor of losses of each current harmonic of three-phase transformers, according to a preferred embodiment of the present invention.
Figure 7 has a possible configuration of the display of short-circuit resistances and load losses of distribution transformers shown on visualisation means of the monitoring device, according to a preferred embodiment of the present invention.
Figure 8 depicts a possible configuration of the display of the factors of monitoring the operation of the distribution transformers shown on visualisation means of the monitoring device, according to a preferred embodiment of the present invention.

### EMBODIMENTS OF THE INVENTION

The limitations of the short-circuit resistance developed by L. Sima *et al.* have been overcome by the inventors of the present invention by developing expressions for the effective short-circuit resistances relating to the secondary winding of the transformer, based on a suitable use of IEEE Standard C57.110-2018. To that end:
Firstly, expressions of the load losses of three-phase transformers with nonlinear loads have been established and are generally applicable. These expressions have been obtained by adapting equation [3], included in IEEE Standard C57.110, to the typical case in which currents are different in the three phases of the transformer. As a result, expression [6] has been developed for the total load losses of the transformer based on the currents of the secondary winding, as follows: ${P}_{cc} = {\sum }_{z = R , S , T} {P}_{cc , z} = \frac{1}{3} ⋅ {\sum }_{z = R , S , T} {\sum }_{{h}_{z}}^{{h}_{z , max}} \left({P}_{DCN}+{P}_{ECN}⋅{h}_{z}^{2}+{P}_{OSLN}⋅{H}_{z}^{0.8}\right) ⋅ {\left(\frac{{I}_{hz}}{{I}_{2 N}}\right)}^{2}$ where *I_{hz}* is the effective value of the current harmonic of order *h_{z} = f_{hz}*/*f*₁ present in the *z* phase *= R, S, T* of the secondary winding of the transformer, *I*_{2*N*} is the nominal value of the current of the secondary winding, and *P_{DCN} = P_{DC-R}, P_{ECN} = P_{EC-R}* and *P_{OSLN} = P_{OSL-R}* are the nominal load losses defined in IEEE Standard C57.110. The use of currents of the secondary winding instead of currents of the primary winding, included in equation [3] and used by L. Sima *et al.* is justified in that the tasks for installing measuring instruments are simpler in the secondary winding than in the primary winding.

Another advantage of equation [6] compared to equation [3] is the possibility of knowing the dissipated load losses in each phase (*z = R, S, T*) of the transformer: ${P}_{cc , z} = \frac{1}{3} ⋅ {\sum }_{{h}_{z} = 1}^{{h}_{z , max}} \left({P}_{DCN}+{P}_{ECN}⋅{h}_{z}^{2}+{P}_{OSLN}⋅{h}_{z}^{0.8}\right) ⋅ {\left(\frac{{I}_{hz}}{{I}_{2 N}}\right)}^{2}$

The effective resistances relating to each phase of the secondary winding of the transformer (*R_{cc,z}*) are therefore defined as those which give rise to load losses *P_{cc,z}* when the currents of those phases circulate through them, i.e.: ${P}_{cc , z} = {R}_{cc , z} ⋅ {\sum }_{{h}_{z} = 1}^{{h}_{z , max}} {I}_{hz}^{2}$

The comparison of equations [7] and [8] determines the expression of the effective short-circuit resistances relating to each phase of the secondary winding of the transformer, constituting a novelty of the present invention: ${R}_{cc , z} = {R}_{DCN} + {R}_{ECN} \frac{{\sum }_{{h}_{z} = 1}^{{h}_{z , max}} {h}_{z}^{2} ⋅ {I}_{hz}^{2}}{{\sum }_{{h}_{z} = 1}^{{h}_{z , max}} {I}_{hz}^{2}} + {R}_{OSLN} \frac{{\sum }_{{h}_{z} = 1}^{{h}_{z , max}} {h}_{z}^{0.8} ⋅ {I}_{hz}^{2}}{{\sum }_{{h}_{z} = 1}^{{h}_{z , max}} {I}_{hz}^{2}}$ wherein ${R}_{DCN} = \frac{{P}_{DCN}}{3 {I}_{2 N}^{2}} {R}_{ECN} = \frac{{P}_{ECN}}{3 {I}_{2 N}^{2}} {R}_{OSLN} = \frac{{P}_{OSLN}}{3 {I}_{2 N}^{2}}$ are the nominal short-circuit resistances relating to the secondary winding of the transformer in the direct current test (*R_{DCN}*), as well as those due to the Skin effect (*R_{ECN}*) and those caused by electromagnetic induction in the metallic parts of the transformer (*R_{OSLN}*), operating at the industrial frequency (50 - 60 Hz). The values of nominal losses *P_{DCN}, P_{ECN}* and *P_{OSLN}* in the above equations can be provided by transformer manufacturers. However, if those values are not available, *P_{DCN}* can be obtained by measuring the direct current losses in the windings of the transformer. Moreover, the nominal load losses of the transformer (*P_{ccN} = P_{DCN} + P_{ECN} + P_{OSLN}*) can be determined by performing a short-circuit test at the industrial frequency (50 - 60 Hz), from where the sum of the other two losses verifies that *P_{SLN} = P_{ECN} + P_{OSLN} = P_{ccN} - P_{DCN}*. Lastly, the values of *P_{ECN}* and *P_{OSLN}* can be obtained separately by applying IEEE Standard C57.12.90, which establishes that in oil immersed transformers *P_{ECN}* = 2/3 · *P_{SLN}* and that in dry type transformers *P_{ECN}* = 1/3 · *P_{SLN}.* If it is desirable to avoid performing the direct current test, the *P_{SLN}* ≈ 0.08 ÷ 0.1 · *P_{ccN}* approach usually provides values of the three nominal losses (*P_{DCN}, P_{ECN}, P_{OSLN}*) that are fairly close to the real values.

For the purpose of simplifying calculation software programming, another expression of the effective short-circuit resistances relating to each phase of the secondary winding of three-phase transformers, developed by the inventors, is the following: ${R}_{cc , z} = {R}_{DCN} + {R}_{ECN} ⋅ {F}_{ECL}^{z} + {R}_{OSLN} ⋅ {F}_{OSL}^{z} = {R}_{DCN} + {R}_{EC , z} + {R}_{OSL , z}$ wherein ${F}_{ECL}^{z} = \frac{{\sum }_{{h}_{z} = 1}^{{h}_{z , max}} {h}_{z}^{2} ⋅ {I}_{hz}^{2}}{{\sum }_{{h}_{z} = 1}^{{h}_{z , max}} {I}_{hz}^{2}} {F}_{OSL}^{z} = \frac{{\sum }_{{h}_{z} = 1}^{{h}_{z , max}} {h}_{z}^{0.8} ⋅ {I}_{hz}^{2}}{{\sum }_{{h}_{z} = 1}^{{h}_{z , max}} {I}_{hz}^{2}}$ are the factors of losses of each phase of the transformer, also established by the inventors and constituting another novelty of the present invention. These factors of losses usually have different values in each phase and are not the same as those included in IEEE Standard C57.110, the values of which relate to the entirety of the transformer.

Likewise, the expressions of the components of the effective short-circuit resistances of each phase relating to the secondary winding ${R}_{EC , z} = {R}_{ECN} ⋅ {F}_{ECL}^{z} {R}_{OSL , z} = {R}_{OSLN} ⋅ {F}_{OSL}^{z}$ included in expression [11], constitute another novelty developed in the present invention.

Based on expressions [9] and [11], it is possible to deduce that effective short-circuit resistances can have different values in each phase, due to the fact that their components *R_{EC,z}* and *R_{OSL,z}* depend on the effective values (*I_{hz}*) and on the frequencies (*h_{z}*) of the harmonics of the currents of each phase, as observed in expression [13].

Additionally, the inventors of the present invention have developed expressions for the short-circuit resistances of each harmonic reduced to the secondary winding (*R_{cc,h}*). These resistances determine the value of the load losses of each phase of the transformer according to the following expression: ${P}_{cc , z} = {\sum }_{{h}_{z} = 1}^{{h}_{z , max}} {R}_{cc , h} ⋅ {I}_{hz}^{2}$

When comparing this latter expression with expression [7], the expression of the short-circuit resistances of each harmonic of order *h_{z},* of the *z* phase = *R, S, T,* reduced to the secondary winding of the transformer, is obtained as follows: ${R}_{cc , h} = {R}_{DCN} + {R}_{ECN} ⋅ {h}_{z}^{2} + {R}_{OSLN} ⋅ {h}_{z}^{0.8}$

The short-circuit resistances expressed by [15] are another novelty of the present invention. It can be seen in [15] that the values of *R_{cc,h},* unlike what occurs with *R_{cc,z},* depend only on the harmonic frequency (*h_{z}*), but not on the effective value of the currents of each phase. Furthermore, since the currents of distribution grids usually have the same harmonics in the three phases, it is concluded that the short-circuit resistances of each harmonic of order *h_{z}* have the same values in the three phases and, therefore, the short-circuit resistances of each harmonic (*R_{cc,h}*) are characteristic parameters of each transformer.

Among all the short-circuit resistances of each harmonic, the one that stands out corresponds to the fundamental frequency (50 - 60 *Hz, h =* 1), ${R}_{cc , 1} = {R}_{DCN} + {R}_{ECN} + {R}_{OLSN} = {R}_{ccN}$

This resistance is independent of the frequency and its value coincides with the value of the nominal short-circuit resistance *R_{ccN},* obtained with equation [2], after performing the nominal short-circuit test of the transformer at the industrial frequency.

By equalising equations [8] and [14], the value of the effective short-circuit resistances of each phase (*z = R, S, T*) is obtained based on the short-circuit resistances of the current harmonics (*I_{hz}*) of that phase: ${R}_{cc , z} = \frac{{\sum }_{{h}_{z} = 1}^{{h}_{z , max}} {R}_{cc , h} ⋅ {I}_{hz}^{2}}{{\sum }_{{h}_{z} = 1}^{{h}_{z , max}} {I}_{hz}^{2}}$

All the short-circuit resistances expressed above relate to the secondary winding of distribution transformers, given that the values of the magnitudes required for the calculation thereof are obtained more easily by measuring in the secondary winding than in the primary winding. However, it is possible to determine the values of those short-circuit resistances relating to the primary winding by simply multiplying the above expressions by the square of the turns ratio of the transformer (*rᵤ* = *V*₁/*V*₂₀), calculated by the ratio between the effective values of the voltage of the primary winding (*V*₁) and the no-load voltage of the secondary winding (*V*₂₀).

To know the state of operational three-phase distribution transformers, the present invention proposes the following operation factors, which are defined with the use of their short-circuit resistances:
- Factor of overheating (*FC_{z}*): defines the increase in the losses in each phase (*z = R, S, T*) in relation to the losses there would be in the transformer operating without nonlinear loads, ${FC}_{z} = \frac{{R}_{cc , z}}{{R}_{ccN}}$
- Factor of supply of each phase (*FS_{z}*%): measures the percentage value of the maximum admissible current and of the power supply in each phase in relation to what the transformer would have operating with linear loads, without harmonics, ${FS}_{z} % = \frac{{I}_{z , max}}{{I}_{N}} ⋅ 100 = \sqrt{\frac{{R}_{ccN}}{{R}_{cc , z}}} ⋅ 100 = \frac{1}{\sqrt{{FC}_{z}}} ⋅ 100$
- Factor of supply of the transformer (*FST*%): determines the maximum percentage availability of power supply (*Sₘₐₓ*) in relation to what the transformer would have operating with linear loads (*S_{N}*)*,* $FST% = \frac{{S}_{max}}{{S}_{N}} ⋅ 100 = \sqrt{\frac{{\sum }_{z = R , S , T} {\left({FS}_{z}\right)}^{2}}{3}} ⋅ 100$
- Factor of losses of each harmonic (*FPₕ*%): defines the percentage importance of each current harmonic in the load losses of the transformer at the fundamental frequency, ${FP}_{h} % = \frac{{P}_{cc , h}}{{P}_{cc , 1}} ⋅ 100 = \frac{{R}_{cc , h}}{{R}_{cc , 1}} ⋅ {\left(\frac{{I}_{h}}{{I}_{1}}\right)}^{2} ⋅ 100$ where ${I}_{h} = \sqrt{{\sum }_{z = R , S , T} {I}_{hz}^{2}}$ is the effective value of the current harmonics of order *h = fₕ*/*f*₁ of the three phases of the transformer and ${I}_{1} = \sqrt{{\sum }_{z = R , S , T} {I}_{1 z}^{2}}$ is the effective value of the three currents of fundamental frequency (*f*₁ = 50 - 60 *Hz*)*.*

Figure 2 depicts the equivalent circuit of a three-phase transformer operating with nonlinear loads. It differs from the transformer model proposed by L. Sima *et al.,* shown in Figure 1, which is based on the direct application of IEEE Standard C57.110, in that the short-circuit resistances have different values in each phase. This fact is important for monitoring the operating state of the transformer, as it indicates that the losses and, therefore, also the temperature and the heating in each of the phases thereof can be different, not only because the circulating currents are different, but also because the resistances of the windings thereof are different due to the Skin phenomenon and the phenomenon of electromagnetic induction.

The meaning of the symbols appearing in Figure 1 is provided below:
- *R_{DC}* are direct current short-circuit resistances of each phase of the windings relating to the primary winding of the transformer.
- *R_{EC}* are the short-circuit resistances relating to the primary winding of L. Sima *et al.* due to the Skin effect of each phase.
- *R_{SL}* are the short-circuit resistances relating to the primary winding of L. Sima *et al.* corresponding to the phenomenon of electromagnetic induction of each phase.
- *X_{cc,p}* are the short-circuit reactances of each phase relating to the primary winding of the transformer.
- *R_{F}* are the loss resistances in the core.
- *X_{µp}* are the magnetising reactances, which characterise the common magnetic flux of the transformer.
- rᵤ is the turns ratio of the transformer.
- I₀ is the no-load current relating to the primary winding.
- Subscripts "p" and "s" denote magnitudes (voltages and currents) of the primary winding and of the secondary winding, respectively: Vₚ is the voltage of each phase of the primary winding; Vₛ is the voltage of each phase of the secondary winding; Iₚ is the current of each phase of the primary winding; Iₛ is the current of each phase of the secondary winding.

The meaning of the symbols appearing in Figure 2 is provided below:
- *R_{cc,R}, R_{cc,S}, R_{cc,T}* denote the short-circuit resistances of the R, S and T phases relating to the secondary winding of the transformer.
- *X_{cc}* are the short-circuit reactances relating to the secondary winding.
- *Rₐ* are the loss resistances in the core relating to the secondary winding.
- *X_{µ}* are the magnetising reactances relating to the secondary winding.
- rᵤ is the turns ratio of the transformer.
- Subscripts "1" and "2" refer to magnitudes of the R, S and T phases of the primary winding and of the secondary winding, respectively: V_{1R}, V_{1S} and V_{1T}, are the voltages of the R, S and T phases of the primary winding, respectively; I_{1R}, I_{1S} and I_{1T} are the currents of the R, S and T phases of the primary winding, respectively; V_{2R}, V_{2S} and V_{2T} are the voltages of the R, S and T phases of the secondary winding, respectively; I_{2R}, I_{2S} and I_{2T} are the currents of the R, S and T phases of the secondary winding, respectively.
- I_{R0}, I_{S0}, I_{T0} denote the no-load currents of the R, S and T phases of the transformer relating to the secondary winding.

According to a preferred embodiment of the invention, the effective short-circuit resistances of each phase (*z = R, S, T*) of the transformer, ${R}_{cc , z} = \frac{{P}_{cc , z}}{{\sum }_{{h}_{z} = 1}^{{h}_{z , max}} {I}_{hz}^{2}}$ are those which lead to the load losses caused by the circulation of currents through each phase of the windings, namely ${P}_{cc , z} = \frac{1}{3} ⋅ {\sum }_{{h}_{z} = 1}^{{h}_{z , max}} \left({P}_{DCN}+{P}_{ECN}⋅{h}_{z}^{2}+{P}_{OSLN}⋅{h}_{z}^{0 , 8}\right) ⋅ {\left(\frac{{I}_{hz}}{{I}_{2 N}}\right)}^{2}$

This latter expression is not included in the text of IEEE Standard C57.110, which only proposes expressions for total load losses, nor is it known in the technical literature.

The substitution of equation [23] in equation [22] determines the expressions of the short-circuit resistances of each phase developed in the present invention: ${R}_{cc , z} = {R}_{DCN} + {R}_{ECN} \frac{{\sum }_{{h}_{z} = 1}^{{h}_{z , max}} {h}_{z}^{2} ⋅ {I}_{hz}^{2}}{{\sum }_{{h}_{z} = 1}^{{h}_{z , max}} {I}_{hz}^{2}} + {R}_{OSLN} \frac{{\sum }_{{h}_{z} = 1}^{{h}_{z , max}} {h}_{z}^{0.8} ⋅ {I}_{hz}^{2}}{{\sum }_{{h}_{z} = 1}^{{h}_{z , max}} {I}_{hz}^{2}}$ or also, in a simplified manner for implementation in calculation and monitoring software, ${R}_{cc , z} = {R}_{DCN} + {R}_{ECN} ⋅ {F}_{ECL}^{z} + {R}_{OSLN} ⋅ {F}_{OSL}^{z}$ wherein ${R}_{DCN} = \frac{{P}_{DCN}}{3 {I}_{2 N}^{2}} {R}_{ECN} = \frac{{P}_{ECN}}{3 {I}_{2 N}^{2}} {R}_{OSLN} = \frac{{P}_{OSLN}}{3 {I}_{2 N}^{2}}$ are direct current nominal short-circuit resistances reduced to the secondary winding (*R_{DCN}*), as well as those due to the Skin effect (*R_{ECN}*) and those caused by electromagnetic induction in the metallic parts of the transformer (*R_{OSLN}*), defined at the industrial frequency (50 - 60 Hz), and ${F}_{ECL}^{z} = \frac{{\sum }_{{h}_{z} = 1}^{{h}_{z , max}} {h}_{z}^{2} ⋅ {I}_{hz}^{2}}{{\sum }_{{h}_{z} = 1}^{{h}_{z , max}} {I}_{hz}^{2}} {F}_{OSL}^{z} = \frac{{\sum }_{{h}_{z} = 1}^{{h}_{z , max}} {h}_{z}^{0.8} ⋅ {I}_{hz}^{2}}{{\sum }_{{h}_{z} = 1}^{{h}_{z , max}} {I}_{hz}^{2}}$ are the factors of losses of each phase (*z = R, S, T*) due to the Skin effect and those caused by electromagnetic induction in the metallic parts of the transformer, respectively. These factors differ from those included in IEEE Standard C57.110 in that they are defined for each phase and not for the entirety of the transformer.

The values of nominal losses *P_{DCN}, P_{ECN}* and *P_{OSLN},* necessary for calculating the three components of the short-circuit resistances at the industrial frequency (*R_{DCN}, R_{ECN}, R_{OSLN}*) in equations [26], are usually provided by transformer manufacturers. However, if those values are not available, the present invention proposes a method for calculating these resistances, being a combination of the experience of the inventors themselves, the performance of tests and the use of existing regulations. This method comprises:
I) Obtaining the values of direct current losses of the windings (*P_{DCN}*) by performing a direct current test of the transformer.
II) Measuring total nominal load losses (*P_{ccN}*) by performing a short-circuit test at the industrial frequency (50 - 60 *Hz*)*.*
III) The application of IEEE Standard C57.90 to calculate the individual values of *P_{ECN}* and of *P_{OSLN},* which establishes *P_{ECN}* = 2/3 · *P_{SLN}* and *P_{OSLN}* = 1/3 · *P_{SLN}* in oil immersed transformers, and *P_{ECN}* = 1/3 · *P_{SLN}* and *P_{OSLN}* = 2/3 · *P_{SLN}* in dry type transformers.

In this aspect of the invention, the calculation of the components of the effective short-circuit resistances relating to each phase of the secondary winding for the Skin phenomenon (*R_{EC,z}*) and the phenomenon of electromagnetic induction (*R_{OSL,z}*) is additionally proposed, as follows: ${R}_{EC , z} = {R}_{ECN} ⋅ {F}_{ECL}^{z}$ ${R}_{OSL , z} = {R}_{OSLN} ⋅ {F}_{OSL}^{z}$

Alternatively, the short-circuit resistances of each phase (*R_{cc,z}*) can be determined based on the short-circuit resistances of the harmonics of that phase (*R_{cc,h}*) according to the following expression: ${R}_{cc , z} = \frac{{\sum }_{{h}_{z} = 1}^{{h}_{z , max}} {R}_{cc , h} ⋅ {I}_{hz}^{2}}{{\sum }_{{h}_{z} = 1}^{{h}_{z , max}} {I}_{hz}^{2}}$

Likewise, proposed is the use of the following expressions ${P}_{cc , z} = {R}_{cc , z} ⋅ {\sum }_{{h}_{z} = 1}^{{h}_{z , max}} {I}_{hz}^{2}$ to calculate the load losses in each phase (*z = R, S, T*) of the transformer, and ${P}_{cc} = {\sum }_{z = R , S , T} {P}_{cc , z} = {\sum }_{z = R , S , T} \left({R}_{cc , z}⋅{\sum }_{{h}_{z} = 1}^{{h}_{z , max}} {I}_{hz}^{2}\right)$ to calculate the total load losses of the transformer.

According to a second preferred embodiment of the invention, the short-circuit resistances for each harmonic (*h_{z}*) of the currents of the secondary winding (*R_{cc,h}*) are obtained as follows: ${R}_{cc , h} = {R}_{DCN} + {R}_{ECN} ⋅ {h}_{z}^{2} + {R}_{OSLN} ⋅ {h}_{z}^{0.8}$

These resistances depend only on the harmonic frequency and, in practice, they are the same in the three phases of the transformer. The present invention uses the short-circuit resistances of each harmonic to calculate the load losses caused by each current harmonic as follows: ${P}_{cc , h} = {R}_{cc , h} ⋅ {\sum }_{z = R , S , T} {I}_{hz}^{2}$ as well as the load losses of each phase: ${P}_{cc , z} = {\sum }_{{h}_{z} = 1}^{{h}_{z , max}} {R}_{cc , h} ⋅ {I}_{hz}^{2}$ and the total load losses of the transformer, according to the following expression: ${P}_{cc} = {\sum }_{{h}_{z} = 1}^{{h}_{z , max}} {P}_{cc , h}$

According to a third preferred embodiment of the invention, proposed are the following factors for the evaluation and monitoring of the operating state of distribution transformers:
- The factor of overheating of each phase (*FC_{z}*), ${FC}_{z} = \frac{{R}_{cc , z}}{{R}_{cc , 1}}$ for monitoring the increase in losses (i.e., from heating) in each phase (*z = R, S, T*) in relation to the losses there would be in the transformer operating without harmonics, where is *R*_{*cc,*1} *= R_{ccN}* the value obtained in [32] with *h_{z} =* 1 (fundamental frequency, 50 - 60 *Hz*)*.*
- The factor of supply of each phase (*FS_{z}*%), ${FS}_{z} % = \sqrt{\frac{{R}_{ccN}}{{R}_{cc , z}}} ⋅ 100 = \frac{1}{\sqrt{{FC}_{z}}} ⋅ 100$ for monitoring the reduced maximum admissible current and power supply in each phase in relation to what the transformer would have operating without harmonics.
- The factor of supply of the transformer (*FST%*), $FST% = \sqrt{\frac{{\sum }_{z = R , S , T} {\left({FS}_{z}\right)}^{2}}{3}} ⋅ 100$ allows the drop in maximum power available for the supply by the transformer operating with current harmonics to be monitored.
- The factor of losses of each harmonic (*FPₕ*%), ${FP}_{h} % = \frac{{P}_{cc , h}}{{P}_{cc , 1}} ⋅ 100$ for knowing the harmonics which lead to the greatest load losses in relation to the losses of the transformer at the fundamental frequency and which, therefore, are the most dangerous for the proper operation of the transformer.

For the sole purpose of exemplifying the advantages of the present invention compared to other known technologies (L. Sima *et al.* and industrial practice), a comparative table is provided below which shows, in a summarised manner, the values of the effective short-circuit resistances of each phase (*R_{cc,R}, R_{cc,S}, R_{cc,T}*) according to the present invention and of the short-circuit resistance of L. Sima *et al.* reduced to the secondary winding ( ${R}_{k}^{′} = {R}_{k} / {r}_{u}^{2}$) recorded every hour, throughout one day, as well as one of the operation factors of the three-phase oil immersed transformer of 630 kVA, Dyn11, with turns ratio *rᵤ* = 57.143 and short-circuit resistance at the industrial frequency of *R_{ccN} = R*_{*cc,*1} = 2,889 *m*Ω, supplying real distribution grid with non-sinusoidal currents. Likewise, said table includes the factors of supply per phase (*FS_{z}*%) and of the transformer (*FST%*) calculated according to expressions [37] and [38] of the present invention, respectively.

| Time slot | ${R}_{k}^{′}$ (*m*Ω) | Effective short-circuit resistances of each phase (*m*Ω) | | | Factors of supply per phase and of the transformer (%) | | | |
|---|---|---|---|---|---|---|---|---|
| | | *R_{cc,R}* | *R_{cc,S}* | *R_{cc,T}* | *FS_{R}* | *FS_{S}* | *FS_{T}* | *FST* |
| 1 | 3.0619 | 3.1010 | 3.0631 | 3.0317 | 96.52 | 97.11 | 97.62 | 97.10 |
| 2 | 3.9307 | 3.9776 | 3.6862 | 4.2624 | 85.22 | 88.53 | 82.33 | 85.40 |
| 3 | 4.1017 | 4.2438 | 4.0317 | 4.0691 | 82.51 | 84.65 | 84.26 | 83.81 |
| 4 | 4.3791 | 4.2894 | 4.2118 | 4.6920 | 82.07 | 82.82 | 78.47 | 81.14 |
| 5 | 4.4171 | 4.2360 | 4.6215 | 4.4031 | 82.58 | 79.06 | 81.00 | 80.90 |
| 6 | 5.3523 | 5.2281 | 5.7393 | 5.0707 | 74.33 | 70.95 | 75.48 | 73.61 |
| 7 | 5.1576 | 4.8258 | 5.1642 | 5.5054 | 77.37 | 74.79 | 72.44 | 74.89 |
| 8 | 3.7214 | 3.7230 | 3.8007 | 3.6654 | 88.09 | 87.18 | 88.78 | 88.02 |
| 9 | 3.7508 | 3.8102 | 3.6656 | 3.7993 | 87.08 | 88.78 | 87.20 | 87.69 |
| 10 | 3.6888 | 3.7989 | 3.5901 | 3.7219 | 87.20 | 89.71 | 88.10 | 88.34 |
| 11 | 3.3915 | 3.2931 | 3.4874 | 3.3905 | 93.66 | 91.02 | 92.31 | 92.33 |
| 12 | 3.0140 | 2.9709 | 3.0369 | 3.0248 | 98.61 | 97.53 | 97.73 | 97.96 |
| 13 | 3.1603 | 3.1766 | 3.1391 | 3.1679 | 95.37 | 95.93 | 95.49 | 95.60 |
| 14 | 3.3981 | 3.4918 | 3.1956 | 3.5652 | 90.96 | 95.08 | 90.02 | 92.04 |
| 15 | 3.5177 | 3.4364 | 3.3420 | 4.1066 | 91.69 | 92.98 | 83.87 | 89.60 |
| 16 | 3.9485 | 3.8337 | 4.4466 | 3.6574 | 86.81 | 81.62 | 88.88 | 85.82 |
| 17 | 4.4318 | 4.2445 | 3.9725 | 4.9727 | 82.50 | 85.28 | 76.22 | 81.42 |
| 18 | 3.5487 | 3.4702 | 3.7127 | 3.4586 | 91.24 | 88.21 | 91.39 | 90.29 |
| 19 | 3.8893 | 3.5395 | 4.0478 | 4.1102 | 90.35 | 84.48 | 83.84 | 86.27 |
| 20 | 3.6337 | 4.1874 | 3.1227 | 4.0181 | 83.06 | 96.18 | 84.79 | 88.20 |
| 21 | 3.1680 | 3.1340 | 3.1763 | 3.1959 | 96.01 | 95.37 | 95.08 | 95.49 |
| 22 | 3.1258 | 3.1460 | 3.1276 | 3.1088 | 95.83 | 96.11 | 96.40 | 96.11 |
| 23 | 3.1703 | 3.2648 | 3.1376 | 3.1449 | 94.07 | 95.96 | 95.84 | 95.29 |
| 24 | 3.3708 | 3.4408 | 3.3223 | 3.3572 | 91.63 | 93.25 | 92.76 | 92.55 |

In view of the table, the following can be deduced:
- The effective short-circuit resistances relating to each phase of the secondary winding (*R_{cc,R}, R_{cc,S}, R_{cc,T}*) obtained according to the technology of the present invention have different values in each phase and, in general, these values are different from the values of the short-circuit resistances relating to the secondary winding of L. Sima *et al.* ( ${R}_{k}^{′} = {R}_{k} / {r}_{u}^{2}$ ) and of the nominal short-circuit resistance (*R_{ccN}*), calculated at the fundamental frequency, the values of which are the same in the three phases of the transformer.
- The greater the differences between the above short-circuit resistances, the more different are the differences in the losses calculated with them. This is confirmed from the values of the factors of supply in the above table. The factors of supply are lower (and, therefore, the load losses are larger) the greater the difference between the effective short-circuit resistances of each phase (*R_{cc,R}, R_{cc,S}, R_{cc,T}*) of the present invention and the short-circuit resistance at the fundamental frequency (*R_{ccN}*). A value of 80% in the factor of supply of one phase means that the current (and, therefore, also power) supply capability in that phase has been reduced to 80% of what it would have without harmonics. Based on the experience of the inventors themselves, a factor of supply below 75% involves significant risks for the proper operation and the service life of the transformer due to the overheating caused by the excessive increase in losses.

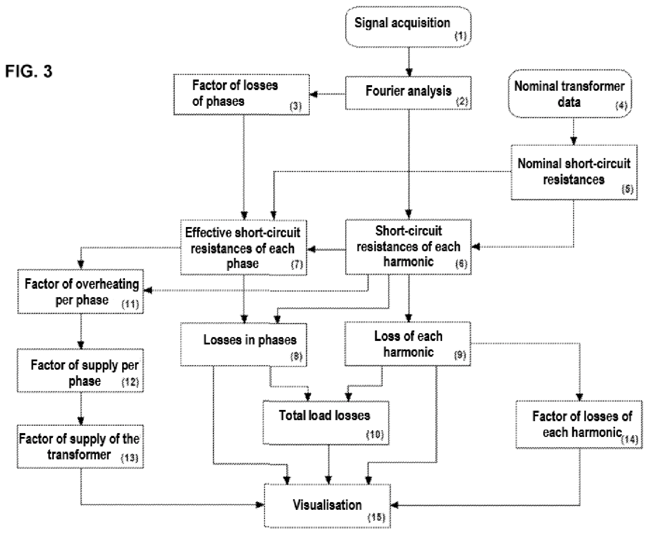

The operating sequence of an exemplary application according to a preferred embodiment of the present invention is explained below with the support of Figure 3. This embodiment focuses on measuring one or more of the following magnitudes of the three-phase distribution transformer subjected to monitoring: the effective short-circuit resistances of each phase, the short-circuit resistances of each current harmonic, the load losses of each harmonic, the load losses of each phase and total load losses of the transformer, as well as the factors of monitoring the transformer. The method shown in Figure 3 comprises the following actions:
I) Electrical signal acquisition (1 in Figure 3):
   Samples of the currents of the secondary winding of the distribution transformer object of monitoring are acquired, and said signals are stored.
II) Signal analysis (2 in Figure 3):
   After acquiring the signals of the currents (in 1 of Figure 3), the corresponding matrices of effective values of those electrical magnitudes (*I_{R}, I_{S}, I_{T}*) and of their harmonic components (*I_{hR}, I_{hS}, I_{hT}*) are obtained (in 2 of Figure 3), preferably by means of a Fourier series.
III) Calculation of the factors of losses of each phase of the transformer (3 in Figure 3):
   From the matrices obtained in the above action (2 in Figure 3), the values of the factors of losses of each phase (*z = R, S, T*) of the transformer are obtained (in 3 of Figure 3) according to equation [27] ${F}_{ECL}^{z} = \frac{{\sum }_{{h}_{z} = 1}^{{h}_{z , max}} {h}_{z}^{2} ⋅ {I}_{hz}^{2}}{{\sum }_{{h}_{z} = 1}^{{h}_{z , max}} {I}_{hz}^{2}} {F}_{OSL}^{z} = \frac{{\sum }_{{h}_{z} = 1}^{{h}_{z , max}} {h}_{z}^{0.8} ⋅ {I}_{hz}^{2}}{{\sum }_{{h}_{z} = 1}^{{h}_{z , max}} {I}_{hz}^{2}}$
IV) Calculation of the components of the nominal short-circuit resistances relating to the secondary winding of the transformer (*R_{DCN}, R_{ECN}, R_{OSLN}*):
   From the nominal losses and currents of the transformer (*P_{DCN}, P_{ECN}, P_{OSLN}, I*_{2*N*}) provided (at 4 according to Figure 3), the nominal short-circuit resistances are obtained (at 5 according to Figure 3) by means of expression [26] ${R}_{DCN} = \frac{{P}_{DCN}}{3 {I}_{2 N}^{2}} {R}_{ECN} = \frac{{P}_{ECN}}{3 {I}_{2 N}^{2}} {R}_{OSLN} = \frac{{P}_{OSLN}}{3 {I}_{2 N}^{2}}$
V) Calculation of the short-circuit resistances of each harmonic (6 in Figure 3):
   From the values of the components of the nominal short-circuit resistances of the transformer (obtained at 5 according to Figure 3, by means of expression [26]), the values of the short-circuit resistances of each current harmonic of the secondary winding of order *h = fₕ*/*f*₁ are obtained (at 6 according to Figure 3) by means of expression [32] ${R}_{cc , h} = {R}_{DCN} + {R}_{ECN} ⋅ {h}_{z}^{2} + {R}_{OSLN} ⋅ {h}_{z}^{0.8}$
VI) Calculation of the effective short-circuit resistances of each phase (7 in Figure 3):
   From the values of the components of the nominal short-circuit resistances (obtained at 5 according to Figure 3) and of the factors of supply of each phase (determined at 3 according to Figure 3, by means of expressions [27]), the values of the effective short-circuit resistances relating to the phases of the secondary winding (*R_{cc,z,} z = R, S, T*) are obtained (at 7 according to Figure 3) by means of expression [25] ${R}_{cc , z} = {R}_{DCN} + {R}_{ECN} ⋅ {F}_{ECL}^{z} + {R}_{OSLN} ⋅ {F}_{OSL}^{z}$ as is the value of the components thereof due to the Skin effect (*R_{EC,z}*) and to the phenomenon of electromagnetic induction (*R_{OSL,z}*) according to expressions [28.1] and [28.2], respectively: ${R}_{EC , z} = {R}_{ECN} ⋅ {F}_{ECL}^{z}$ ${R}_{OSL , z} = {R}_{OSLN} ⋅ {F}_{OSL}^{z}$ Alternatively, the effective short-circuit resistances of each phase can be calculated (at 7 according to Figure 3) from the short-circuit resistances of the harmonics of that phase (obtained at 6 according to Figure 3) by means of expression [29]: ${R}_{cc , z} = \frac{{\sum }_{{h}_{z} = 1}^{{h}_{z , max}} {R}_{cc , h} ⋅ {I}_{hz}^{2}}{{\sum }_{{h}_{z} = 1}^{{h}_{z , max}} {I}_{hz}^{2}}$
VII) Calculation of the load losses of each phase (8 in Figure 3):
   From the values of the effective short-circuit resistances relating to each phase of the secondary winding of the transformer (obtained at 7 according to Figure 3) and the effective values of the harmonics of the currents of each phase (obtained at 2 in Figure 3), the load losses of each phase (*P_{cc,z}*) are obtained (at 8 according to Figure 3) by means of expression [30] ${P}_{cc , z} = {R}_{cc , z} ⋅ {\sum }_{{h}_{z} = 1}^{{h}_{z , max}} {I}_{hz}^{2}$ Alternatively, these losses can also be calculated from the values of the short-circuit resistances of each current harmonic of the secondary winding, *R_{cc,h},* (obtained at 6 according to Figure 3) and the effective values of the harmonics of the currents of each phase, *I_{hz}* (obtained at 2 in Figure 3), by means of expression [34] ${P}_{cc , z} = {\sum }_{{h}_{z} = 1}^{{h}_{z , max}} {R}_{cc , h} ⋅ {I}_{hz}^{2}$
VIII) Calculation of the load losses of each harmonic (9 in Figure 3):
   From the values of the short-circuit resistances of each harmonic of the currents of each phase of the secondary winding, *R_{cc,h},* (obtained at 6 according to Figure 3 by means of expression [32]) and the effective values of the harmonics of the currents of each phase, *I_{hz}* (obtained at 2 in Figure 3), the load losses of each harmonic (*P_{cc,h}*) are obtained (at 9 according to Figure 3) by means of expression [33] ${P}_{cc , h} = {R}_{cc , h} ⋅ {\sum }_{z = R , S , T} {I}_{hz}^{2}$
IX) Calculation of the total load losses of the transformer (10 in Figure 3):
   From the values of the load losses of each phase *P_{cc,z}* (obtained at 8 according to Figure 3, by means of expressions [30] or [34]), the values of the total load losses of the transformer (at 10 according to Figure 3) are obtained by means of expression [31] ${P}_{cc} = {\sum }_{z = R , S , T} {P}_{cc , z}$ Alternatively, the values of the total load losses of the transformer (*P_{cc}*) can be obtained (at 10 according to Figure 3) from the values of the load losses of each harmonic *P_{cc,h}* (obtained at 9 according to Figure 3) by means of expression [35] ${P}_{cc} = {\sum }_{{h}_{z} = 1}^{{h}_{z , max}} {P}_{cc , h}$
X) Calculation of the factor of overheating of each phase (11 in Figure 3):
   From the effective short-circuit resistances of each phase (obtained at 7 according to Figure 3 by means of expression [25] or [29]) and from the short-circuit resistance at the fundamental frequency (obtained at 6 according to Figure 3 by means of expression [32]), the factors of overheating of each phase are obtained (at 11 according to Figure 3) by means of expression [36] ${FC}_{z} = \frac{{R}_{cc , z}}{{R}_{cc , 1}}$
XI) Calculation of the factor of supply of each phase (12 in Figure 3):
   From the coefficients of overheating of each phase (obtained at 11 according to Figure 3 by means of expressions [36]), the factors of supply of each phase are obtained (at 12 according to Figure 3) by means of expression [37] ${FS}_{z} % = \frac{1}{\sqrt{{FC}_{z}}} ⋅ 100$
XII) Calculation of the factor of supply of the transformer (13 in Figure 3):
   From the factors of supply of each phase (obtained at 12 according to Figure 3 by means of expressions [37]), the factors of supply of each phase are obtained (at 13 according to Figure 3) by means of expression [38] $FST% = \sqrt{\frac{{\sum }_{z = R , S , T} {\left({FS}_{z}\right)}^{2}}{3}} ⋅ 100$
XIII) Calculation of the factors of losses of each harmonic (14 in Figure 3):
   From the load losses of the harmonic of order *h* and of the fundamental harmonic, *h =* 1, (obtained at 9 according to Figure 3 by means of expression [33]), the factors of losses of each harmonic are obtained (at 14 according to Figure 3) by means of expression [39] ${FP}_{h} % = \frac{{P}_{cc , h}}{{P}_{cc , 1}} ⋅ 100$
XIV) Visualisation (15 in Figure 3):
   The values of the magnitude or magnitudes obtained according to the method (effective short-circuit resistances and the losses in each phase, short-circuit resistances and losses of each harmonic, total load losses, factor of overheating and factor of supply of each phase, factor of supply of the transformer and factor of losses of each harmonic) are shown on visualisation means.

According to another aspect, the present invention also provides a device (A) for monitoring the operating state of a three-phase distribution transformer based on the use of the effective short-circuit resistances of each phase and of the short-circuit resistances of each harmonic, described above. Likewise, the device (A) allows the method described above to be carried out; namely, several of the magnitudes and monitoring parameters of the distribution transformer, such as effective values of the currents of the phases and the harmonic components thereof, the factors of losses of each phase, the short-circuit resistances and the load losses corresponding to each phase and to each harmonic, the total load losses of the transformer, as well as the factors of monitoring can be obtained by means of the device (A) of the present invention.

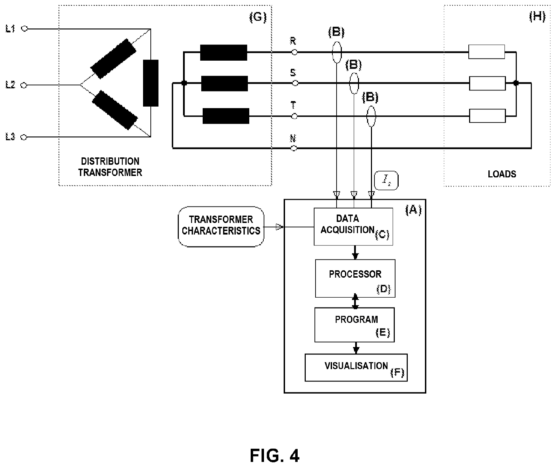

As shown in Figure 4, the device (A) of the present invention is a measuring device comprising: a physical system for measuring and acquiring electrical signals (C); a processing system (D); and a measuring program (E) in charge of obtaining the value of one or more electrical magnitudes of the transformer (G) subjected to monitoring when it supplies loads (H). The device (A) of the present invention also comprises visualisation means (F), preferably a display, which displays the value of the electrical magnitudes and of the monitoring parameters obtained, which allow the operation of the distribution transformer to be monitored.

According to a preferred embodiment, the physical system for measuring and acquiring electrical signals (C) comprises: current measurement sensors (B); signal conditioners; and a data acquisition card. The signal conditioners are in charge of adapting instantaneous values of the currents obtained by means of the current measurement sensors (B), such that the voltages at the outputs of the signal conditioners are applicable to the analog inputs of the data acquisition card. The data acquisition card converts the voltage and current analog signals into a series of discrete samples, which are used as inputs of the measuring program (E).

Preferably, the physical system for measuring and acquiring electrical signals (C) is arranged in the lines of the secondary winding of the transformer as shown in Figure 4, such that it can acquire signals of the line currents of the secondary winding (*I_{R}, I_{S}, I_{T}*) of the distribution transformer. According to one option, the nominal values of the load losses and of the currents of the secondary winding of the transformer are input into the physical system for measuring and acquiring electrical signals (C) and stored so that they can subsequently be used depending on the magnitudes and parameters to be obtained.

According to a preferred embodiment, the processing system (D) is connected to a mother board, to which the data acquisition card is also connected, which allows the exchange of the discrete samples of the voltage and intensity signals with the measuring program (E).

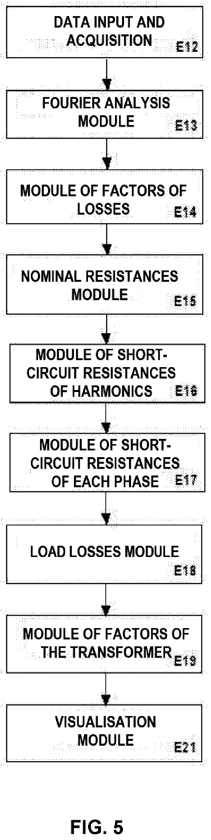

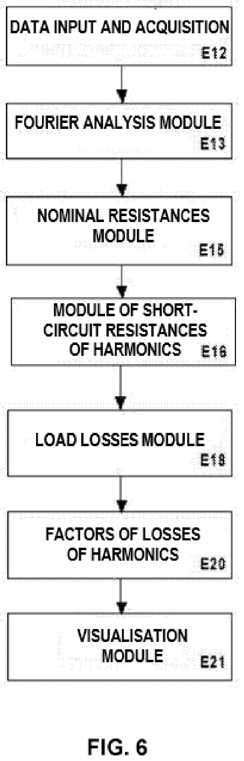

According to a preferred embodiment, the measuring program (E) comprises the following modules (depicted in Figures 5 and 6): a data input and acquisition module (E12); a Fourier analysis module (E13); a module of factors of losses of each phase (E14); a nominal short-circuit resistances module (E15); a module of short-circuit resistances of each harmonic (E16); a module of effective short-circuit resistances of each phase (E17); a load losses module (E18); a module of factors of supply of the transformer (E19); a module of factors of losses of harmonics (E20); and a visualisation module (E21).

The data input and acquisition module (E12) is in charge of receiving current samples and storing them in a vector for each one of them.

The Fourier analysis module (E13) is in charge of obtaining, from the samples received in the data input and acquisition module (E12), the effective values of the harmonic components of said current samples, obtained by the Fourier series.

The module of factors of losses of each phase (E14) is in charge of obtaining the factors of losses due to the Skin effect and to the phenomenon of electromagnetic induction in each of the phases of the transformer ( ${F}_{ECL}^{z} , {F}_{OSL}^{z}$), from the information obtained in the Fourier analysis module (E13) according to expression [27].

The nominal short-circuit resistances module (E15) is in charge of obtaining the values of the components of the nominal short-circuit resistances (*R_{DCN}, R_{ECN}, R_{OSLN}*) based on the input values of the nominal losses and currents of the transformer (*P_{DCN}*, *P_{ECN}, P_{OSLN}, I*_{2*N*}) according to expression [26].

The module of short-circuit resistances of each harmonic (E16) is in charge of obtaining the values of the short-circuit resistances for each of the frequencies of the current harmonics of each phase (*R_{cc,h}*) according to expression [32].

The module of effective short-circuit resistances of each phase (E17) is in charge of obtaining the values of the effective short-circuit resistances of each phase of the transformer (*R_{cc,z}*) according to expression [25], and of the components thereof (*R*_{*EC,*z} , *R_{OSL,z}*) according to expressions [28.1] and [28.2]. Alternatively, the effective short-circuit resistances of each phase of the transformer (*R_{cc,z}*) can be calculated based on the short-circuit resistances of the harmonics (*R_{cc,h}*) according to expression [29].

The load losses module (E18) is in charge of obtaining the values of the load losses of each phase (*P_{cc,z}*) according to expression [30], the total load losses of each harmonic (*P_{cc,h}*) according to expression [33], and the total load losses of the transformer (*P_{cc}*) according to expression [31]. Alternatively, the losses in each of each phase can be calculated based on the short-circuit resistances of the harmonics (*R_{cc,h}*) according to expression [34], and the total load losses of the transformer can be obtained according to expression [35].

The module of factors of supply of the transformer (E19) is in charge of obtaining the values of the factor of overheating of each phase (*FC_{z}*) according to expression [36], of the factor of supply of each phase (*FS_{z}*%) according to expression [37], and of the factor of supply of the transformer (*FST*%) according to expression [38].

The module of factors of losses of harmonics (E20) is in charge of obtaining the values of the factors of losses for each harmonic of the currents (*FPₕ*%) according to expression [39].

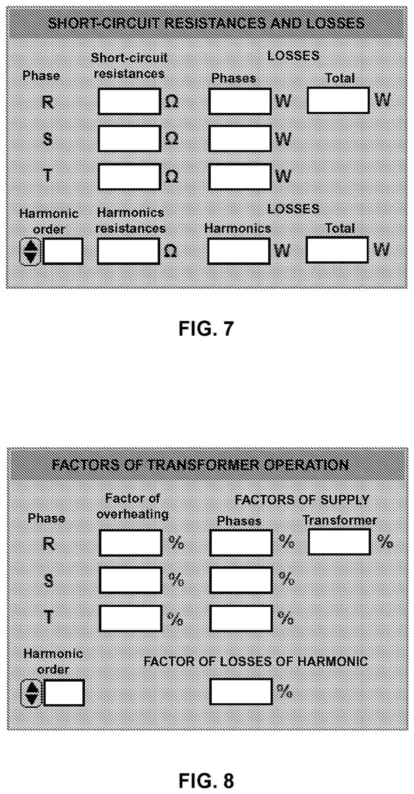

The visualisation module (E21) is in charge of showing on the visualisation means (F) the information of one or more magnitudes of the distribution transformer obtained by the device (A). A first preferred embodiment shows one or more electrical magnitudes selected from the group comprising: the effective short-circuit resistances of each phase, the short-circuit resistance of the selected harmonic of order *h*, the load losses of each phase, the total load losses of the transformer and the load losses of the selected harmonic, as shown on a first display of the visualisation means (F) in Figure 7.

Likewise, in another preferred embodiment, the visualisation means (F) show on a second display, depicted in Figure 8, the following parameters for monitoring the transformer: the factor of overheating of each phase, the factor of supply of each phase, the factor of supply of the transformer and the factor of losses of the selected harmonic of order *h*.

According to a preferred embodiment shown in Figures 5 and 6, the measuring program (E) comprises the aforementioned modules E12 - E21. More specifically, Figure 5 shows the modules of the measuring program (E) configured to intervene in the measurement and visualisation of the effective short-circuit resistances of each phase and of the load losses and the factors of monitoring the transformer obtained with those resistances (namely the modules E12 - E19 and E21); and Figure 6 shows the modules of the measuring program (E) configured to intervene in the measurement and visualisation of the short-circuit resistances of the harmonics, the load losses of each harmonic and the factor of losses of each harmonic (namely, modules E12, E13, E15, E16, E18, E20 and E21).

Although the present invention has been described in reference to particular options and embodiments thereof, those skilled in the art may make modifications and variations to the above teachings without departing from the scope and spirit of the present invention.

## Claims

1. Use of short-circuit resistances for monitoring the operating state of an operational three-phase transformer, **characterised in that** said resistances are effective short-circuit resistances relating to the secondary winding of the three-phase transformer, with the particularity that the effective short-circuit resistance relating to a *z* phase of the secondary winding (*R_{cc,z}*) is that which gives rise to dissipated load losses in the z phase (*P_{cc,z}*) when current circulates through the z phase, as shown in the following expression: ${R}_{cc , z} = \frac{{P}_{cc , z}}{{\sum }_{{h}_{z} = 1}^{{h}_{z , max}} {I}_{hz}^{2}}$ wherein:
- *z* generally denotes any one phase of the secondary winding of the transformer,
- *R_{cc,z}* is the effective short-circuit resistance relating to the *z* phase of the transformer,
- *P_{cc,z}* are the dissipated load losses in the *z* phase,
- *h_{z}* is the order of a current harmonic present in the z phase, said order being defined as the ratio between the harmonic frequency (*fₕ*) and the fundamental frequency (*f*₁),
- *h_{z,max}* is the order of the current harmonic of the highest frequency present in the *z* phase used in the calculation,
- *I_{hz}* is the effective value of the current harmonic of order *h_{z}.*

2. Use of short-circuit resistances according to claim 1, with the particularity that the dissipated load losses in the *z* phase (*P_{cc,z}*) encompass several types of losses according to the following expression: ${P}_{cc , z} = \frac{1}{3} ⋅ {\sum }_{{h}_{z} = 1}^{{h}_{z , max}} \left({P}_{DCN}+{P}_{ECN}⋅{h}_{z}^{2}+{P}_{OSLN}⋅{h}_{z}^{0 , 8}\right) ⋅ {\left(\frac{{I}_{hz}}{{I}_{2 N}}\right)}^{2}$ wherein:
- *P_{DCN}* are direct current nominal load losses,
- *P_{ECN}* are nominal load losses due to the Skin effect,
- *P_{OSLN}* are nominal load losses caused by the phenomenon of electromagnetic induction,
- *I*_{2*N*} is the nominal value of the current of the secondary winding of the transformer.

3. Use of short-circuit resistances according to any of the preceding claims, with the particularity that the effective short-circuit resistances are expressed in reference to the primary winding of the transformer by multiplying the effective short-circuit resistances relating to the secondary winding (*R_{cc,z}*) by the square of a turns ratio of the transformer *rᵤ* = *V*₁/*V*₂₀, wherein:
- *V*₁ is the effective value of the voltage of the primary winding, and
- *V*₂₀ is the effective value of the no-load voltage of the secondary winding.

4. Use of short-circuit resistances according to any of the preceding claims, with the particularity that the effective short-circuit resistances relating to the secondary winding of the transformer (*R_{cc,z}*) are related to short-circuit resistances of the current harmonics relating to the secondary winding of the transformer (*R_{cc,h}*)*,* according to the following expression: ${R}_{cc , z} = \frac{{\sum }_{{h}_{z}}^{{h}_{z , max}} {R}_{cc , h} ⋅ {I}_{hz}^{2}}{{\sum }_{{h}_{z} = 1}^{{h}_{z , max}} {I}_{hz}^{2}}$

5. Use of short-circuit resistances according to claim 4, with the particularity that the short-circuit resistances of current harmonics relating to the secondary winding of the transformer (*R_{cc,h}*) are related to nominal short-circuit resistances of the transformer according to the following expression: ${R}_{cc , h} = {R}_{DCN} + {R}_{ECN} ⋅ {h}_{z}^{2} + {R}_{OSLN} ⋅ {h}_{z}^{0.8}$ wherein:
- *R_{DCN}* is a direct current nominal short-circuit resistance relating to the secondary winding,
- *R_{ECN}* is a nominal short-circuit resistance relating to the secondary winding due to the Skin effect,
- *R_{OSLN}* is a nominal short-circuit resistance relating to the secondary winding caused by electromagnetic induction in the metallic parts of the transformer.

6. Use of short-circuit resistances according to either of claims 4 or 5, with the particularity that the short-circuit resistances of current harmonics are expressed in reference to the primary winding by multiplying the short-circuit resistances of current harmonics relating to the secondary winding of the transformer (*R_{cc,h}*) by the square of a turns ratio of the transformer *rᵤ = V*₁/*V*₂₀, wherein:
- *V*₁ is the effective value of the voltage of the primary winding, and
- *V*₂₀ is the effective value of the no-load voltage of the secondary winding.

7. A method for monitoring the operating state of an operational three-phase transformer based on the use of short-circuit resistances described in any of claims 1 to 6, **characterised in that** it comprises obtaining, by means of a monitoring device, the value of at least one magnitude of the transformer selected from the group comprising: short-circuit resistances of harmonics relating to the secondary winding of the transformer (*R_{cc,h}*)*,* short-circuit resistances of harmonics relating to the primary winding of the transformer, effective short-circuit resistances relating to the secondary winding of the transformer (*R_{cc,z}*), component of said effective short-circuit resistances due to the Skin effect (*R_{EC,z}*), component of said effective short-circuit resistances due to the phenomenon of electromagnetic induction (*R_{OSL,z}*), effective short-circuit resistances relating to the primary winding of the transformer, load losses of each phase of the secondary winding of the transformer (*P_{cc,z}*), load losses of each harmonic (*P_{cc,h}*), total load losses (*P_{cc}*), factor of overheating of each phase (*FC_{z}*), factor of supply of each phase (*FS_{z}*%), factor of supply of the transformer (*FST*%), factor of losses of each harmonic (*FPₕ*%), according to the following particularities:
a) the value of short-circuit resistances of harmonics relating to the secondary winding of the transformer (*R_{cc,h}*) is obtained by means of expression [32]: ${R}_{cc , h} = {R}_{DCN} + {R}_{ECN} ⋅ {h}_{z}^{2} + {R}_{OSLN} ⋅ {h}_{z}^{0.8}$ wherein:
- *R_{cc,h}* is the short-circuit resistance of a current harmonic relating to the *z* phase of the secondary winding of the transformer,
- *z* generally denotes any one phase of the secondary winding of the transformer,
- *h_{z}* is the order of a current harmonic present in the *z* phase, said order being defined as the ratio between the harmonic frequency (*fₕ*) and the fundamental frequency (*f*₁),
- *R_{DCN}, R_{ECN}, R_{OSLN}* are a direct current nominal short-circuit resistance relating to the secondary winding (*R_{DCN}*), a nominal short-circuit resistance relating to the secondary winding due to the Skin effect (*R_{ECN}*) and a nominal short-circuit resistance relating to the secondary winding caused by electromagnetic induction in the metallic parts of the transformer (*R_{OSLN}*), respectively, which are obtained by means of expressions [26] ${R}_{DCN} = \frac{{P}_{DCN}}{3 {I}_{2 N}^{2}} {R}_{ECN} = \frac{{P}_{ECN}}{3 {I}_{2 N}^{2}} {R}_{OSLN} = \frac{{P}_{OSLN}}{3 {I}_{2 N}^{2}}$ wherein:
· *P_{DCN}* are direct current nominal load losses,
· *P_{ECN}* are nominal load losses due to the Skin effect,
· *P_{OSLN}* are nominal load losses caused by the phenomenon of electromagnetic induction,
· *I*_{2*N*} is the nominal value of the current of the secondary winding of the transformer;
b) the value of short-circuit resistances of harmonics relating to the primary winding of the transformer is obtained by multiplying the short-circuit resistances of current harmonics relating to the secondary winding of the transformer (*R_{cc,h}*) by the square of a turns ratio of the transformer *rᵤ* = *V*₁/*V*₂₀, wherein:
- *V*₁ is the effective value of the voltage of the primary winding, and
- *V*₂₀ is the effective value of the no-load voltage of the secondary winding;
c) the value of the effective short-circuit resistances relating to the secondary winding of the transformer (*R_{cc,z}*) is obtained by means of one of the following options:
c1) by means of expression [25]: ${R}_{cc , z} = {R}_{DCN} + {E}_{ECN} ⋅ {F}_{ECL}^{z} + {R}_{OSLN} ⋅ {F}_{OSL}^{z}$ wherein:
- *R_{cc,z}* is the effective short-circuit resistance relating to the z phase of the transformer,
- *R_{DCN}, R_{ECN}, R_{OSLN}* are a direct current nominal short-circuit resistance relating to the secondary winding (*R_{DCN}*), a nominal short-circuit resistance relating to the secondary winding due to the Skin effect (*R_{ECN}*) and a nominal short-circuit resistance relating to the secondary winding caused by electromagnetic induction in the metallic parts of the transformer (*R_{OSLN}*), respectively, which are obtained by means of expressions [26] ${R}_{DCN} = \frac{{P}_{DCN}}{3 {I}_{2 N}^{2}} {R}_{ECN} = \frac{{P}_{ECN}}{3 {I}_{2 N}^{2}} {R}_{OSLN} = \frac{{P}_{OSLN}}{3 {I}_{2 N}^{2}}$ wherein:
· *P_{DCN}* are direct current nominal load losses,
· *P_{ECN}* are nominal load losses due to the Skin effect,
· *P_{OSLN}* are nominal load losses caused by the phenomenon of electromagnetic induction,
· *I*_{2*N*} is the nominal value of the current of the secondary winding of the transformer;
- ${F}_{ECL}^{z} , {F}_{OSL}^{z}$ are a Skin-effect induced factor of losses of the *z* phase ( ${F}_{ECL}^{z}$), and a factor of losses of the *z* phase caused by electromagnetic induction in the metallic parts of the transformer ( ${F}_{OSL}^{z}$), respectively, which are obtained by means of expressions [27] ${F}_{ECL}^{z} = \frac{{\sum }_{{h}_{z} = 1}^{{h}_{z , max}} {h}_{z}^{2} ⋅ {I}_{hz}^{2}}{{\sum }_{{h}_{z} = 1}^{{h}_{z , max}} {I}_{hz}^{2}} {F}_{OSL}^{z} = \frac{{\sum }_{{h}_{z} = 1}^{{h}_{z , max}} {h}_{z}^{0.8} ⋅ {I}_{hz}^{2}}{{\sum }_{{h}_{z} = 1}^{{h}_{z , max}} {I}_{hz}^{2}}$ wherein:
· *h_{z}* is the order of a current harmonic present in the *z* phase, said order being defined as the ratio between the harmonic frequency (*fₕ*) and the fundamental frequency (*f*₁),
· *h_{z,max}* is the order of the current harmonic of the highest frequency present in the z phase used in the calculation,
· *I_{hz}* is the effective value of the current harmonic of order *h_{z}*;
c2) by means of expression [29] ${R}_{cc , z} = \frac{{\sum }_{{h}_{z} = 1}^{{h}_{z , max}} {R}_{cc , h} ⋅ {I}_{hz}^{2}}{{\sum }_{{h}_{z} = 1}^{{h}_{z , max}} {I}_{hz}^{2}}$ wherein:
- *R_{cc,z}* is the effective short-circuit resistance relating to the *z* phase of the transformer,
- *R_{cc,h}* is the short-circuit resistance of a current harmonic relating to the *z* phase of the secondary winding of the transformer,
- *h_{z}* is the order of a current harmonic present in the *z* phase, said order being defined as the ratio between the harmonic frequency (*fₕ*) and the fundamental frequency (*f*₁),
- *h_{z,max}* is the order of the current harmonic of the highest frequency present in the *z* phase used in the calculation,
- *I_{hz}* is the effective value of the current harmonic of order *h_{z}*;
d) the value of the component due to the Skin effect (*R_{EC,z}*) of the effective short-circuit resistances of each phase relating to the secondary winding (*R_{cc,z}*) is obtained by means of expression [28.1] ${R}_{EC , z} = {R}_{ECN} ⋅ {F}_{ECL}^{z}$ wherein:
- *R_{ECN}* are the nominal load losses due to the Skin effect,
- ${F}_{ECL}^{z}$ is the factor of losses of the z phase due to the Skin effect;
e) the value of the component due to the phenomenon of electromagnetic induction (*R_{OSL,z}*) of the effective short-circuit resistances of each phase relating to the secondary winding (*R_{cc,z}*) is obtained by means of expression [28.2] ${R}_{OSL , z} = {R}_{OSLN} ⋅ {F}_{OSL}^{z}$ wherein:
- *R_{OSLN}* is the nominal short-circuit resistance relating to the secondary winding caused by electromagnetic induction in the metallic parts of the transformer,
- ${F}_{OSL}^{z}$ is the factor of losses of the *z* phase caused by electromagnetic induction in the metallic parts of the transformer;
f) the value of the effective short-circuit resistances relating to the primary winding of the transformer is obtained by multiplying the effective short-circuit resistances relating to the secondary winding of the transformer (*R_{cc,z}*) by the square of a turns ratio of the transformer *rᵤ = V*₁/*V*₂₀, wherein:
- *V*₁ is the effective value of the voltage of the primary winding, and
- *V*₂₀ is the effective value of the no-load voltage of the secondary winding;
g) the value of the load losses of each phase of the secondary winding of the transformer (*P_{cc,z}*) is obtained by means of one of the following options:
g1) by means of expression [30] ${P}_{cc , z} = {R}_{cc , z} ⋅ {\sum }_{{h}_{z} = 1}^{{h}_{z , max}} {I}_{hz}^{2}$ wherein:
- *R_{cc,z}* is the effective short-circuit resistance relating to the *z* phase of the transformer,
- *h_{z}* is the order of a current harmonic present in the *z* phase, said order being defined as the ratio between the harmonic frequency (*fₕ*) and the fundamental frequency (*f*₁),
- *h_{z,max}* is the order of the current harmonic of the highest frequency present in the *z* phase used in the calculation,
- *I_{hz}* is the effective value of the current harmonic of order *h_{z}*;
g2) by means of expression [34] ${P}_{cc , z} = {\sum }_{{h}_{z} = 1}^{{h}_{z , max}} {R}_{cc , h} ⋅ {I}_{hz}^{2}$ wherein:
- *h_{z}* is the order of a current harmonic present in the *z* phase, said order being defined as the ratio between the harmonic frequency (*fₕ*) and the fundamental frequency (*f*₁),
- *h_{z,max}* is the order of the current harmonic of the highest frequency present in the *z* phase used in the calculation,
- *R_{cc,h}* is the short-circuit resistance of a current harmonic relating to the *z* phase of the secondary winding of the transformer,
- *I_{hz}* is the effective value of the current harmonic of order *h_{z}*;
h) the value of the load losses of each harmonic (*P_{cc,h}*) is obtained by means of expression [33]: ${P}_{cc , h} = {R}_{cc , h} ⋅ {\sum }_{z = R , S , T} {I}_{hz}^{2}$ wherein:
- *z* generally denotes any one phase of the secondary winding of the transformer,
- *R, S, T* specifically denote each of the three phases of the secondary winding of the transformer, respectively,
- *I_{hz}* is the effective value of the current harmonic of order *h_{z},*
- *R_{cc,h}* is the short-circuit resistance of a current harmonic relating to the *z* phase of the secondary winding of the transformer;
i) the value of the total load losses (*P_{cc}*) is obtained by means of one of the following options:
i1) by means of expression [31]: ${P}_{cc} = {\sum }_{z = R , S , T} {P}_{cc , z}$ wherein:
- *z* generally denotes any one phase of the secondary winding of the transformer,
- *R, S, T* specifically denote each of the three phases of the secondary winding of the transformer, respectively,
- *P_{cc,z}* are the load losses of each phase of the secondary winding of the transformer;
i2) by means of expression [35]: ${P}_{cc} = {\sum }_{{h}_{z} = 1}^{{h}_{z , max}} {P}_{cc , h}$ wherein:
- *h_{z}* is the order of a current harmonic present in the *z* phase, said order being defined as the ratio between the harmonic frequency (*fₕ*) and the fundamental frequency (*f*₁),
- *h_{z,max}* is the order of the current harmonic of the highest frequency present in the *z* phase used in the calculation,
- *P_{cc,h}* are the load losses of each harmonic;
j) the value of the factor of overheating of each phase (*FC_{z}*) is obtained by means of expression [36]: ${FC}_{z} = \frac{{R}_{cc , z}}{{R}_{cc , 1}}$ wherein:
- *FC_{z}* is the factor of overheating, which defines the increase in losses in each *z* phase in relation to the losses there would be in the transformer operating without nonlinear loads,
- *R_{cc,z}* is the effective short-circuit resistance relating to the *z* phase of the transformer,
- *R*_{*cc,*1} is the short-circuit resistance of a harmonic (*R_{cc,h}*) at the fundamental frequency, i.e., of the harmonic of order *h*=1;
k) the value of the factor of supply of each phase (*FS_{z}*%) is obtained by means of expression [37]: ${FS}_{z} % = \frac{1}{\sqrt{{FC}_{z}}} ⋅ 100$ wherein:
- *FS_{z}*% is the factor of supply of each phase, which measures the percentage value of the maximum admissible current and of the power supply in each phase in relation to what the transformer would have operating with linear loads, without harmonics,
- *FC_{z}* is the factor of overheating of each *z* phase, expressed on a per unit basis;
l) the value of the factor of supply of the transformer (*FST*%) is obtained by means of expression [38]: $FST% = \sqrt{\frac{{\sum }_{z = R , S , T} {\left({FS}_{z}\right)}^{2}}{3}} ⋅ 100$ wherein
- *FST*% is the factor of supply of the transformer, which determines the maximum percentage availability of power supply in relation to what the transformer would have operating with linear loads,
- *z* generally denotes any one phase of the secondary winding of the transformer,
- *R, S, T* specifically denote each of the three phases of the secondary winding of the transformer, respectively,
- *FS_{z}* is the factor of supply of each *z* phase, expressed on a per unit basis;
m) the value of the factor of losses of each harmonic (*FPₕ*%) is obtained by means of expression [39]: ${FP}_{h} % = \frac{{P}_{cc , h}}{{P}_{cc , 1}} ⋅ 100$ wherein:
- *FPₕ*% is the factor of losses of each harmonic, which defines the percentage importance of each current harmonic in the load losses of the transformer at the fundamental frequency,
- *P_{cc,h}* are the load losses of the harmonic of order *h,*
- *P*_{*cc,*1} are the load losses of the fundamental harmonic, i.e., the harmonic of order *h*=1.

8. A method according to claim 7, wherein the value of nominal losses *P_{DCN}, P_{ECN}, P_{OSLN}* is obtained by means of one of the following options:
i) according to one option, the value of nominal losses *P_{DCN}, P_{ECN}, P_{OSLN}* is provided by transformer manufacturer;
ii) according to another option, the value of nominal losses *P_{DCN}, P_{ECN}, P_{OSLN}* is obtained by means of the following actions:
- the value of *P_{DCN}* is obtained by measuring the losses in the windings of the transformer by means of a direct current test;
- the value of total nominal load losses of the transformer (*P_{ccN}*) is obtained by performing a short-circuit test;
- the values of *P_{ECN}* and *P_{OSLN}* are obtained by means of the following expressions:
*P_{ECN}* = 2/3 · *P_{SLN}* and *P_{OSLN}* = 1/3 *· P_{SLN},* in the case of an oil immersed transformer, and
*P_{ECN}* = 1/3 · *P_{SLN}* and *P_{OSLN}* = 2/3 · *P_{SLN},* in the case of a dry type transformer, wherein ${P}_{SLN} = {P}_{ECN} + {P}_{OSLN} = {P}_{ccN} - {P}_{DCN} ;$
iii) according to another option, the value of nominal losses *P_{DCN}, P_{ECN}, P_{OSLN}* is obtained by means of the following actions:
- the value of total nominal load losses of the transformer (*P_{ccN}*) is obtained by performing a short-circuit test;
- the values of *P_{ECN}* and *P_{OSLN}* are obtained by means of the following expressions: ${P}_{ECN} = 2 / 3 ⋅ {P}_{SLN} and {P}_{OSLN} = 1 / 3 ⋅ {P}_{SLN} ,$ in the case of an oil immersed transformer, and ${P}_{ECN} = 1 / 3 ⋅ {P}_{SLN} and {P}_{OSLN} = 2 / 3 ⋅ {P}_{SLN} ,$ in the case of a dry type transformer;
- the value of *P_{DCN}* is obtained from the following expression: ${P}_{SLN} = {P}_{ECN} + {P}_{OSLN} = {P}_{ccN} - {P}_{DCN} ;$ with the particularity that the value of *P_{SLN}* is assigned according to the following expression: ${P}_{SLN} \approx 0.08 \div 0.1 ⋅ {P}_{ccN} .$

9. The method according to any of claims 7 or 8, wherein the effective value of the harmonics of the currents of each phase (*I_{hz}*) are obtained from received current samples of the transformer by means of a Fourier series analysis of said samples.

10. The method according to any of claims 7 to 9, wherein the received current samples of the transformer are acquired by means of current measurement sensors.

11. A device (A) for monitoring the operating state of an operational three-phase transformer (G) based on the use of short-circuit resistances described in any of claims 1 to 6, **characterised in that** it comprises:
- a physical system for measuring and acquiring electrical signals (C);
- a processing system (D); and
- a measuring program (E) in charge of obtaining the value of one or more electrical magnitudes of the transformer (G) subjected to monitoring when it supplies loads (H).

12. The device (A) according to claim 11, comprising visualisation means (F), preferably a display, which displays the information of one or more of the obtained electrical magnitudes of the transformer.

13. The device (A) according to either of claims 11 or 12, wherein the physical system for measuring and acquiring electrical signals (C) comprises:
- current measurement sensors (B);
- signal conditioners; and
- a data acquisition card;
with the particularity that the signal conditioners are in charge of adapting instantaneous values of the currents obtained by means of the current measurement sensors (B), such that the voltages at the outputs of the signal conditioners are applicable to the analog inputs of the data acquisition card; and the data acquisition card converts the voltage and current analog signals in a series of discrete samples, which are used as inputs of the measuring program (E).

14. The device (A) according to claim 13, wherein the processing system (D) is connected to a mother board, to which the data acquisition card is also connected, which allows the exchange of the discrete samples of the voltage and intensity signals with the measuring program (E).

15. The device (A) according to any of claims 11 to 14, wherein the measuring program (E) comprises the following modules:
- a data input and acquisition module (E12), which is in charge of receiving current samples and storing them in a vector for each one of them;
- a Fourier analysis module (E13), which is in charge of obtaining, from the samples received in the data input and acquisition module (E12), the effective values of the harmonic components of said current samples, obtained by the Fourier series;
- a module of factors of losses of each phase (E14), which is in charge of obtaining the factors of losses due to the Skin effect and to the phenomenon of electromagnetic induction in each of the phases of the transformer ( ${F}_{ECL}^{z} , {F}_{OSL}^{z}$), from the information obtained in the Fourier analysis module (E13);
- a nominal short-circuit resistances module (E15), which is in charge of obtaining the values of the components of the nominal short-circuit resistances (*R_{DCN}, R_{ECN}, R_{OSLN}*) based on the input values of the nominal losses and currents of the transformer (*P_{DCN}, P_{ECN}, P_{OSLN}, I*_{2*N*});
- a module of short-circuit resistances of each harmonic (E16), which is in charge of obtaining the values of the short-circuit resistances for each of the frequencies of the current harmonics of each phase (*R_{cc,h}*);
- a module of effective short-circuit resistances of each phase (E17), which is in charge of obtaining the values of the effective short-circuit resistances of each phase of the transformer (*R_{cc,z}*), and of the components thereof (*R_{EC,z} , R_{OSL,z}*);
- a load losses module (E18), which is in charge of obtaining the values of the load losses of each phase (*P_{cc,z}*), the total load losses of each harmonic (*P_{cc,h}*), and the total load losses of the transformer (*P_{cc}*);
- a module of factors of supply of the transformer (E19), which is in charge of obtaining the values of the factor of overheating of each phase (*FC_{z}*), of the factor of supply of each phase (*FS_{z}*%), and of the factor of supply of the transformer (*FST*%);
- a module of factors of losses of harmonics (E20), which is in charge of obtaining the values of the factors of losses for each harmonic of the currents (*FPₕ*%); and
- a visualisation module (E21), which is in charge of showing on the visualisation means (F) the information of one or more magnitudes of the distribution transformer obtained by the device (A).
